# EUROPEAN PATENT SPECIFICATION

(11) **EP 3 527 995 B1**
(45) Date of publication and mention of the grant of the patent: **25.01.2023**
(21) Application number: 18382100.8
(22) Date of filing: 20.02.2018
(51) Int. Cl.: G01R 1/20, G01R 19/00, G01R 19/32

(54) **SHUNT RESISTOR AND MEASUREMENT SYSTEM**
SHUNTWIDERSTAND UND MESSSYSTEM
RÉSISTANCE DE DÉRIVATION ET SYSTÈME DE MESURE

(43) Date of publication of application: 21.08.2019
(73) Proprietor: Fico Triad, S.A., 08028 Barcelona (ES)
(72) Inventor: SALA MASIP, Enric, 08232 Viladecavalls (Barcelona) (ES)
(74) Representative: Elzaburu S.L.P.

(56) References cited:
- EP-A1- 0 030 186
- EP-A1- 2 068 402
- FR-A1- 2 884 615
- US-A1- 2008 050 985
- US-A1- 2014 125 429
- US-A1- 2015 102 897
- US-A1- 2015 219 690
- US-A1- 2016 111 189
- US-A1- 2016 231 359
- US-A1- 2016 291 059
- US-A1- 2017 059 632
- US-A1- 2017 243 679

## Description

### Field of the invention

The invention is related to a shunt resistor and a corresponding measurement system comprising said shunt resistor that avoid the inaccuracies introduced by the known Seebeck effect.

### Background of the invention

For the measurement of currents in electric circuits, a typical solution is to use current sensors based on shunt resistors. A shunt resistor is a low resistance resistor used in series in the electric circuit where the current is to be measured. The current flowing through the resistor produces a voltage drop that is proportional to the current. That voltage can be measured by electronic circuits.

In order to make the measurements nondependent on the temperature, the shunt resistor metal is based on alloys with null temperature coefficient, typically Manganine, Constantan or Nickel-Chrome alloys.

For the connection of the shunt resistor into the main circuit, a typical design of the component is based on two adjacent plates of, for instance, Copper alloys, at both sides of the shunt resistor metal. The design of the plates depends on the type of connection to the main circuit. As example, some plates with holes to connect power cables or bus bars or, some plate pads to be soldered by Surface Mount Technology (SMT) into a Printed Circuit Board (PCB).

In addition to the main current connections, there are additional signal connections, just to collect the voltage read out. These signal connections are derived from the plates by screwed cables, soldered pins or soldered cables.

Therefore, a known shunt resistor comprises a shunt body comprising a shunt resistor metal and two adjacent connecting plates for the connection of the shunt resistor to a circuit, being the shunt resistor metal located in between the two connecting plates. Additionally, the shunt resistor comprises at least two signal connections located in the connecting plates and configured for collecting the voltage read out at both longitudinal sides of the shunt body in order to know the voltage drop at the shunt resistor.

It is known that in the joints between two different conductive materials a thermoelectric effect can happen, known as Seebeck effect. According to this effect, a pair of metals can produce an electric voltage in the joint, depending on the temperature. Hence, the Seebeck effect is the conversion of heat directly into electricity at the junction of different types of materials.

The connecting plates of the shunt resistor are frequently made of Copper and the shunt resistor metal is frequently made of Manganine, therefore in a typical chain of materials of Copper - Manganine - Copper, as used in known shunt resistors, there are two joints, each joint producing opposite voltages. For example, if the joint Copper - Manganine produces a positive voltage (v1), then the joint Manganine - Copper produces a negative voltage (v2).

In case that the temperature at both joints was the same, the value of the voltage at each joint would be also be the same (|v1|=|v2|), but being both voltages with opposite polarity the overall voltage between terminals would be cancelled (v=(v1+v2)=0).

A problem occurs when the shunt resistor doesn't have the same temperature at both ends. In that case, the voltages produced by the Seebeck effect are different (|v1|<>|v2|) and the total voltage between terminal is different from zero (v=(v1+v2)<>0).

This voltage produced by the Seebeck effect is overlapped with the voltage generated by the current flowing through the component and produces inaccuracies in the read out.

This problem is likely to happen because, in most of the systems, it cannot be guaranteed that the temperature was the same at both ends of the shunt resistor. The gradient of temperature in the shunt resistor is due to the fact that, in a complete system, the shunt resistor is connected to different components at each side, with different thermal conditions, i.e., power dissipation, thermal resistance, etc, thus producing a thermal gradient along the shunt resistor. In addition, the shunt resistor can receive heat from nearby components and even the actual current flowing through the shunt itself could cause a temperature differential in the shunt resistor.

In order to solve the problem of the Seebeck effect, some countermeasures have been proposed, based on the real measurement of the temperatures with thermistors at both sides of the shunt resistor and a subsequent compensation of the measurements by software.

These types of implementations, based on temperature measurement, are not performing correctly in dynamic situations, because of the thermal inertia and the inaccuracies of the temperature sensors.

It is known document US2017/059632 A1 disclosing shunt arrangements and current measuring circuits for temperature compensated current measurements as well as current measurements that are compensated for changes in the characteristics of the shunt material as a result of manufacturing tolerances. The current measuring circuits may include a temperature sensing element in a negative feedback path of an operational amplifier for providing temperature compensation. The shunt arrangements may include a calibration shunt formed in the same material as a main shunt and circuitry for measuring the temperature drift error of the calibration shunt and applying that error to compensate for temperature drift of the main shunt.

It is also known document US2014/125429 A1 disclosing a voltage detection circuit, which can remove influence of error voltage caused by tiny amount of self-inductance existing in a shunt resistor, though in the resistor for large current usage, which is impossible to surface-mount on a voltage detection circuit board. The shunt resistor device comprises: a resistance body; a pair of main electrode for flowing current to be monitored through the resistance body; a pair of detection terminal for detecting voltage caused in the resistance body; and a pair of wiring each electrically connected to the detection terminal. And, a pair of voltage detection wiring consisting of the detection terminal and the wiring is brought closer, at prescribed location, than distance between each of connection position of the pair of the detection terminal on the main electrode. A low-pass filter having resistance value (r) and capacitance (C) is provided at next stage after the pair of the wiring, and said low-pass filter having a relationship Le/R=C·r, when Le (=L-M) is the effective inductance, and R is the resistance value of the resistance body.

It is also known document FR2884615 A1 disclosing a device having a shunt with two ends connected to the connecting terminals. A printed circuit has an electronic component with electrical connecting lugs. The lugs are connected to the terminals by conducting units which are connected to the terminals by upper and lower tracks and orifices. The unit has thermoelectric properties similar to the shunt, where the shunt and the unit are made of Manganin (RTM: copper, nickel and manganese alloy) and Zeranin (RTM: copper, germanium and manganese alloy).

It is also known document US2016/291059 A1 disclosing current sensors, systems and methods. A test current is injected via a pair of force terminals into a conductor and a pair of sense terminals are configured to provide an input signal that corresponds to a voltage drop across the conductor. Based on the test current in the conductor and based on the input signal, a contribution to the voltage drop due to the test current and a contribution to the voltage drop due to a primary current through the conductor may be determined. In addition, at least one of a reference resistance of the conductor and the primary current in the conductor may be further determined.

It is also known document US2015/219690 A1 disclosing a current sensor including a die and a shunt resistor having a first temperature coefficient and having a first node and a second node fabricated onto the die, wherein the shunt resistor is for passing the current that is to be sensed. A first compensation resistor is fabricated onto the die and is coupled to the first node of the shunt resistor, wherein the first compensation resistor is proximate the shunt resistor and has a temperature coefficient that is similar to the temperature coefficient of the shunt resistor. A second compensation resistor is fabricated onto the die and is coupled to the second node of the shunt resistor, wherein the second compensation resistor is proximate the shunt resistor and has a temperature coefficient that is the close to the temperature coefficient of the shunt resistor.

It is also known document EP0030186 A1 disclosing a watt-hour shunt with reduced voltage error.

### Summary of the invention

The claimed invention is characterised in that two signal connections configured for collecting the voltage read out are connected directly to the shunt resistor metal and are made of the same metal than the shunt resistor metal.

The signal connections may be of different known types as pins or screws or even a welded connection.

Hence, the proposed solution to the above mentioned technical problem is to avoid the combination of metals in the shunt body. This is achieved by the measurement wires being connected directly over the shunt resistor metal through the signal connections that are made of the same material instead of, for instance, being connected to the adjacent copper plates.

It is also an object of the present invention a measurement system as defined in claim 1.

According to the above measurement system, the sensing wires configured for collecting the voltage read out are additionally made with the same material than the shunt resistor metal, preferably, with the same alloy than the shunt resistor metal.

Therefore, within the sensing circuit for collecting the voltage read out there will be no joint with different materials as the joint plate - shunt resistor metal of the shunt resistor as it will be allocated beyond the sensing area, for instance, at least until the entrance of the measurement device performing the voltage drop calculation where the connection could be made at low distance between both wires and where the gradient of temperature would be nearly inexistent and therefore the tensions due the Seebeck effect would be negligible.

The advantage of having the wires made of the same material than the shunt resistor metal is with respect to the possibility of having, for instance, the measuring device located directly at the signal connections or of the wires being made of copper, that in these two cases there would be a "great" Seebeck effect since the temperature gradient is usually much higher in the shunt resistor than in the measurement device, which makes the measurement much more precise.

### Description of the figures

To complete the description and in order to provide for a better understanding of the invention, a set of drawings is provided. Said drawings form an integral part of the description and illustrate preferred embodiments of the invention. The drawings comprise the following figures.
Figure 1 shows a known shunt resistor and a measurement system using this known shunt resistor in the state of the art.
Figure 2 shows an embodiment of a shunt resistor and a measurement system using this shunt resistor according an embodiment of the invention.

### Detailed description of the invention

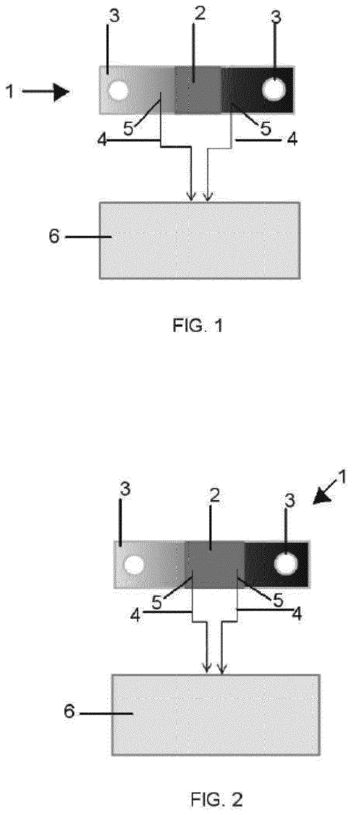

Figure 1 shows a known shunt resistor comprising a shunt body (1) comprising:
- a shunt resistor metal (2), made for example of Manganine,
- two adjacent connecting plates (3), made of Copper, and
- two signal connections (5) placed at both longitudinal sides of the shunt body (1), specifically joined to the connecting plates (3).

Moreover, figure 1 also shows a measurement system using this known shunt resistor comprising:
- the already mentioned shunt resistor,
- two wires (4) made for instance of Copper configured for collecting the voltage read out through their connection to the signal connections (5), and
- a measurement device (6) connected to the wires (4).

Therefore, there is a Seebeck effect emanating from the joint between the shunt resistor metal (2) and the adjacent connecting plates (3) due to both elements are made of different material.

Figure 2 shows an embodiment of the shunt resistor of the invention showing also a shunt body (1) comprising a shunt resistor metal (2), made of Manganine for the example, two adjacent connecting plates (3), made of Copper for the example, and two signal connections (5) made of the same material than the shunt resistor metal (2), made of Manganine for the example and located in the shunt resistor metal (2).

The shunt resistor metal (2) could be made of a Manganine, Constantan or Nickel-Chrome alloy and the two adjacent connecting plates (3) could be made of Copper or of an alloy of the same material than the shunt resistor metal (2) or even of the same material.

Figure 2 also shows an embodiment of a measurement system comprising a shunt resistor according to the invention, a measurement device (6), and two wires (4) made of the same material than the shunt resistor metal (2), Manganine for example, configured for collecting the voltage read out through their connection to the signal connections (5) and in electrical connection to the measurement device (6).

Hence, according to the previous embodiments, the interface between Manganine and Copper, within the sensing circuit, will be done at the measurement device (6), where the wires (4) are connected to the PCB. As previously explained, being both wires (4) connected very close, no difference in temperature is expected at that point and is also expected no difference of voltage due to Seebeck effect.

As an example, the following standard shunt resistors are provided:
- Shunt at 170 A and 100 µΩ:
   ∘ Manganine shunt resistor (3) length: 3,0 mm,
   ∘ distance between the signal connections (5) in the connecting plates (3) made of Copper: 3,6 mm.
- Shunt at 600 A and 100 µΩ:
   ∘ Manganine shunt resistor (3) length: 9,3 mm,
   ∘ distance between the signal connections (5) in the connecting plates (3) made of Copper: 12,6 mm.
- Shunt at 700 A y 100 µΩ:
   ∘ Manganine shunt resistor (3) length: 18,5 mm,
   ∘ distance between the signal connections (5) in the connecting plates (3) made of Copper: 21,6 mm.

As can be seen, the length of the shunt resistor metal (2) and the distance between the signal connections (5) are not negligible in shunt resistors for certain intensities, therefore a gradient of temperature would appear.

## Claims

1. Measurement system, comprising:
- a measurement device (6), and
- a shunt resistor comprising a shunt body (1) comprising:
- two connecting plates (3) configured for the connection of the shunt resistor to a circuit, and
- a shunt resistor metal (2) located in between the two connecting plates (3) and based on alloys with null temperature coefficient,
- two signal connections (5) configured for the connection of the shunt resistor to the measurement device (6), the two signal connections (5) being located at the shunt resistor metal (2) and being made of the same material than the shunt resistor metal (2),
**characterised in that** the measurement system further comprises two measurement wires (4) configured for being in electrical connection with the measurement device (6), the two measurement wires (4) being connected over the shunt resistor metal (2) through the signal connections (5) and being made of an alloy of the same material than the shunt resistor metal (2).

2. Measurement system, according to claim 1, wherein the shunt resistor metal (2) is made of either a Manganine, Constantan or Nickel-Chrome alloy.

3. Measurement system, according to claims 1 or 2, wherein the two connecting plates (3) are made of Copper.

4. Measurement system, according to claim 1 or 2, wherein the two connecting plates (3) are made of an alloy of the same material than the shunt resistor metal (2).

5. Measurement system, according to claim 4, wherein the two connecting plates (3) are made of the same material than the shunt resistor metal (2).

## Patentansprüche

1. Messsystem, umfassend:
- eine Messvorrichtung (6), und
- einen Shunt-Widerstand, umfassend einen Shunt-Körper (1), umfassend:
- zwei Anschlussplatten (3), die für den Anschluss des Shunt-Widerstands an eine Schaltung konfiguriert sind, und
- ein Shunt-Widerstandsmetall (2), das sich zwischen den beiden Verbindungsplatten (3) befindet und Auf Legierungen mit Null-Temperatur-Koeffizient basiert,
- zwei Signalanschlüsse (5), die für die Verbindung des Shunt-Widerstands mit der Messvorrichtung (6) konfiguriert sind, wobei die beiden Signalanschlüsse (5) sich am Shunt-Widerstandsmetall (2) befinden und aus dem gleichen Material wie das Shunt-Widerstandsmetall (2) bestehen,
**dadurch gekennzeichnet, dass** das Messsystem ferner zwei Messdrähte (4) umfasst,
Die konfiguriert sind, um in elektrischer Verbindung mit der Messvorrichtung (6) zu stehen, wobei die beiden Messdrähte (4) über das Shunt-Widerstandsmetall (2) durch die Signalanschlüsse (5) verbunden sind und aus einer Legierung des gleichen Materials wie das Shunt-Widerstandsmetall (2) hergestellt sind.

2. Messsystem nach Anspruch 1, wobei das Shunt-Widerstandsmetall (2) entweder aus einer Mangan-, Konstantan- oder Nickel-Chrom-Legierung hergestellt ist.

3. Messsystem nach Anspruch 1 oder 2, wobei die beiden Verbindungsplatten (3) aus Kupfer sind.

4. Messsystem nach Anspruch 1 oder 2, wobei die beiden Verbindungsplatten (3) aus einer Legierung aus dem gleichen Material wie das Shunt-Widerstandsmetall (2) hergestellt sind.

5. Messsystem nach Anspruch 4, wobei die beiden Verbindungsplatten (3) aus dem gleichen Material wie das Shunt-Widerstandsmetall (2) hergestellt sind.

## Revendications

1. Système de mesure comprenant :
- un dispositif de mesure (6), et
- une résistance de dérivation comprenant un corps de dérivation (1) comprenant :
- deux plaques de connexion (3) configurées pour la connexion de la résistance shunt à un circuit, et
- un métal de résistance shunt (2) situé entre les deux plaques de connexion (3) et à base sur les alliages à coefficient de température nulle,
- deux connexions de signal (5) configurées pour la connexion de la résistance de shunt au dispositif de mesure (6), les deux connexions de signal (5) étant situées au niveau du métal de résistance de shunt (2) et étant faites du même matériau que le métal de résistance de shunt (2),
**caractérisé en ce que** le système de mesure comprend en outre deux fils de mesure (4)
configurés pour être en connexion électrique avec le dispositif de mesure (6), les deux fils de mesure (4) étant connectés par l'intermédiaire des connexions de signal (5) sur le métal de résistance shunt (2) et étant constitués d'un alliage du même matériau que le métal de résistance shunt 20 (2).

2. Système de mesure selon la revendication 1, dans lequel le métal de résistance shunt (2) est constitué d'un alliage de manganine, de manganèse ou de nickel-chrome.

3. Système de mesure selon la revendication 1 ou 2, dans lequel les deux plaques de connexion (3) en cuivre.

4. Système de mesure selon la revendication 1 ou 2, dans lequel les deux plaques de connexion (3) sont constituées d'un alliage du même matériau que le métal de résistance shunt (2).

5. Système de mesure selon la revendication 4, dans lequel les deux plaques de connexion (3) sont constituées du même matériau que le métal de résistance shunt (2).
